(19) Europäisches Patentamt
European Patent Office
Office européen des brevets

(11) EP 0 969 324 A1

(12) # EUROPEAN PATENT APPLICATION

(43) Date of publication:
**05.01.2000 Bulletin 2000/01**

(51) Int Cl.7: **G03F 7/033**

(21) Application number: **99305236.4**

(22) Date of filing: **01.07.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **02.07.1998 US 109807**

(71) Applicant: **MORTON INTERNATIONAL, INC.**
**Chicago, Illinois 60606 (US)**

(72) Inventor: **Brewster, Wanda Darlene**
**Tustin, California 92780 (US)**

(74) Representative:
**Bankes, Stephen Charles Digby et al**
**BARON & WARREN**
**18 South End**
**Kensington**
**London W8 5BU (GB)**

(54) **One part photoimageable composition for forming solder mask**

(57) The invention provides an alkaline aqueous developable photoimageable composition, useful as a photoresist for forming a solder mask on a printed circuit board. The photoimageable composition comprises

A) between 20 and 50 wt% of a binder polymer, the binder polymer (A) comprising a backbone formed of between 45 and 75 mole percent styrene and between 25 and 55 mole percent maleic anhydride, the binder polymer being esterified with an organic alcohol or mixture of organic alcohols each having a molecular weight between 32 and 200 so as to at least half-esterify the anhydride functionality provided by maleic anhydride. The polymer has an acid number between 110 and 270 and a weight average molecular weight between 10,000 and 150,000. Between 20 and 75 wt% of the photoimageable composition comprises
B) photopolymerizeable compounds, including between 20 and 60 wt% of acrylate-functional oligomers selected from:

$B_1$) acrylate functional urethane oligomers having weight average molecular weights between 400 and 3000, and/or
$B_2$) epoxy acrylate oligomers having weight average molecular weights between 400 and 3000.

To achieve a final hardening cure, the composition further contains

C) between 1 and 5 wt% of an aminoplast which, at elevated temperatures reacts with any hydroxyl functional present and with the acid functionality of the binder polymer (A). The composition further contains
D) between 1 and 15 wt% of a photoinitiator chemical system to promote polymerization of the photopolymerizeable compounds (B) when exposed to actinic radiation.

EP 0 969 324 A1

## Description

The present invention is directed to a photoimageable composition useful for forming solder masks on printed circuitry. The photoimageable compositions are stable as one-part compositions, and therefore useful for forming dry films in which a stable, one-part composition is required for reasonable shelf-life. The composition is tack-free and suitable for contact imaging. The composition provides good encapsulation of printed circuitry traces. The composition is heat-resistant and provides heat stability through repeated soldering at high temperatures.

Photoimageable compositions useful, for example, as photoresists for forming printed circuit boards are taught in U.S. Patent No. 3,953,309 to Gilano et al., the teachings of which are incorporated herein by reference. The major components of the composition are a photopolymerizeable material, e.g., an $\alpha,\beta$-ethylenically unsaturated monomer or short chain oligomer, a photoinitiator chemical system, and an acid functional binder, such as a copolymer of styrene and monobutyl maleate. The photoimageable composition taught in U.S. 3,953,309 also has a free radical inhibitor to prevent premature thermal-initiated polymerization.

The photoimageable compositions taught in U.S. 3,953,309 are developable in alkaline aqueous solution, such as dilute sodium carbonate solution, as a result of significant carboxylic acid functionality of the binder polymer. For example, in a styrene/monobutyl maleate polymer, each monobutyl maleate residue provides one non-esterified carboxylic moiety. A layer of photoimageable composition, subsequent to patterned exposure to actinic radiation and development in alkaline aqueous solution to remove non-exposed portions of the layer, are exposed to an acid etch solution, such as ferric chloride, to etch underlying copper from a circuit board blank.

Photoimageable compositions using as binder polymers of styrene and monoesters of maleic anhydride are also taught in U.S. Patents Nos. 4,273,857 and 4,293,635, the teachings of each of which are incorporated herein by reference. Binders which are copolymers of styrene and monoesters of maleic anhydride are commercially available, e.g., Scripset® resins sold by Monsanto Chemical Co.

While the post-development processing in U.S. 3,953,309 is in an acidic solution, other post development processing is conducted in highly alkaline solutions, such as ammoniacal etchants or metal plating solutions. The acid functionality of the polymers in the patents referenced above, while rendering them developable in alkaline aqueous solutions, also render even the exposed, photopolymerized portions of the resist layer subject to degradation in highly alkaline aqueous solutions. In highly alkaline environments, such resists would be subject to delamination and stripping.

U.S. Patent No. 4,987,054 describes the use of an amine-modified methyl methacrylate/styrene/maleic anhydride "copolymer" which can be thermally cured after exposure and development. This thermal cure produces a film which has excellent resistance to alkaline processing environments. However, the additional post-development thermal curing step can be impractical in high volume printed circuit board production.

U.S. Patent No. 4,008,087 describes styrene/maleic anhydride copolymers esterified with phenethanol. The polymers are used in silver halide photoemulsions.

U.S. Patent No. 4,722,947 describes radiation curable polymers which are styrene/maleic anhydride copolymers that are esterified with a hydroxyalkyl acrylyl compound and optionally with another alcohol, such as an arylalkyl monohydric alcohol. The compositions containing the esterified polymer are useful in radiation cured compositions, such as coatings, adhesives and films.

U.S. Patent No. 4,273,857 describes photoimageable compositions containing styrene/maleic anhydride copolymers partially esterified with methanol and isopropanol.

Photoimageable compositions are also known which, following exposure to actinic radiation and development, are post-hardenable and therefore suitable for use in forming solder masks or the like. U.S. Patent No. 5,364,736 describes such a composition using an epoxy resin to provide the post-cure hardness. Epoxy-containing photoresists, such as those described in Patent No. 5,364,736 which have acid functional binder polymers for alkaline aqueous developability, must generally be provided in two parts that are mixed together just prior to application as liquid photoimageable compositions to printed circuit boards. A one-part composition of this type would be unstable as the epoxy functionality would react over time with the carboxylic acid functionality of the binder polymer.

U.S. Patent No. 5,609,991, the teachings of which are incorporated herein by reference, describes photoimageable compositions, including photoimageable compositions suitable for forming solder masks. Styrene/maleic anhydride polymers of relatively high molecular weight and a relatively high degree of esterification are used as binder polymers. The compositions of this patent have good heat resistance, attributable to the styrene/maleic anhydride copolymers. However, styrene/maleic anhydride copolymers are brittle polymers, and the solder mask-forming compositions described in this patent have been found not to encapsulate circuitry traces to the degree desired.

In accordance with the invention, there is provided a one part, alkaline aqueous developable, photoimageable composition suitable for forming a solder mask. Herein, all weight percentages by which the photoimageable composition are described are calculated relative to a binder polymer A), photopolymerizeable compounds B) and aminoplast resin C). The photoimageable composition comprises A) between 20 and 50 wt% of a binder polymer, the binder polymer A) comprising a backbone formed of between 45 and 75 mole percent styrene and between 25 and 55 mole

percent maleic anhydride, the binder polymer being esterified with an organic alcohol or mixture of organic alcohols each having a molecular weight between 32 and 200 so as to at least half-esterify the anhydride functionality provided by maleic anhydride. The polymer has an acid number between 110 and 270 and a weight average molecular weight between 10,000 and 150,000, preferably at least 20,000 and preferably no greater than 60,000. Between 20 and 75 wt% of the photoimageable composition comprises photopolymerizeable compounds, including between 20 and 60 wt% of acrylate-functional oligomers selected from $B_1$) acrylate functional urethane oligomers having weight average molecular weights between 400 and 3000, and/or $B_2$) epoxy acrylate oligomers having weight average molecular weights between 400 and 3000, the oligomers $B_1$) and/or $B_2$) preferably having weight average molecular weights of 2000 or below, plus optionally $B_3$) from 0 to 15 wt% of acrylate-functional monomers. To achieve a final hardening cure, the composition further contains C) between 1 and 5 wt% of an aminoplast which, at elevated temperatures, reacts with any hydroxyl functional present and with the acid functionality of the binder polymer A). The composition further contains D) between 1 and 15 wt% of a photoinitiator chemical system to promote polymerization of the photopolymerizeable compounds B) when exposed to actinic radiation.

The invention is particularly directed to a photoimageable composition for secondary imaging, particularly as for forming a solder mask. By solder mask is meant, herein, a hard, permanent layer which meets at least the minimal requirements of the abrasion resistance test as defined in IPC-SM-840B, Table 12, Summary of Criteria for Qualification/Conformance (Institute for Interconnecting and Packaging Electronic Circuits).

Styrene comprises between about 45 and about 75 mole percent of the binder polymer backbone with maleic anhydride comprising the remaining 25 to 55 mole percent. The relative amounts of styrene and maleic anhydride will generally determine the acid number of the binder polymer A) because, when fully half-esterified with an organic alcohol, each anhydride moiety will provide one carboxylic acid functionality. However, it is possible to further esterify the binder polymer by reaction of organic alcohols with the carboxylic acid functionality that results from esterification of the anhydride.

It is necessary, however, that the binder polymer be fully half-esterified, i.e., that substantially all of the anhydride groups are reacted with the alcohol(s).

Anhydride groups are quite reactive with aminoplast resins, and premature cross-linking would occur if there were any significant amount of anhydride moieties remaining in the binder polymer after esterification.

The choice of organic alcohol is not considered particularly important. Methanol, MW 32, may be the esterifying alcohol, as may be higher molecular weight alcohols, i.e., up to a MW of about 200, preferably no greater than about 130. Above-referenced U.S. Patent 5,609,991 teaches esterifying with relatively bulky alcohols having MWs over 100, such as 3-cyclohexyl-1-propanol, cyclohexylmethanol, phenylethyl alcohol, methyl cyclohexanol and 2-ethyl-1-hexanol. It is taught, however, that due to the bulk of these alcohols, half-esterification tends not to be complete, making it necessary to achiever full half-esterification with a 1-3 carbon alcohol, particularly methanol. While such mixed alcohol esterified styrene/maleic anhydride polymers are useful in the present invention, they are not required herein. Additional chemical functionality, such as the additional hydroxyl groups provided by polyols, is not desired if such functionality will either cross-link the SMA polymer during esterification or if it will prematurely react with the aminoplast. If a higher cross-link density is desired, the alcohol may have acrylate functionality, e.g., hydroxyethylacrylate or hydroxyethylmethacrylate, whereby the acrylate functionality of the binder polymer enters into the photopolymerization reaction. However, sufficient cross-link density is generally achievable without the binder polymer containing acrylate functionality.

Above-referenced U.S. Patent No. 5,609,991 teaches esterified styrene/maleic anhydride polymers having molecular weights (weight average) between about 80,000 and 200,000. Herein, a lower molecular weight (weight average) range is employed, i.e., between about 10,000 and about 150,000. It is preferred that the weight average molecular weight be at least about 20,000. For processing at temperatures whereat photoimageable compositions are conventionally processed, i.e., at temperatures of about 70°C and below, it is generally required that the weight average molecular weight of the esterified styrene/maleic anhydride be about 60,000 or below in order to obtain good encapsulation of circuitry traces. Above this, e.g., up to about 150,000, the photoimageable compositions must be treated at temperatures above conventional processing temperatures to achieve adequate encapsulation of circuitry traces.

In most photoimageable compositions of this general type, the photoimageable compound(s) are predominantly monomers having mono- and poly-acrylate functionality. However, such monomers have been used in conjunction with acrylate functional oligomers. For example, above-referenced U.S. Patent No. 5,609,991, 5 to 10 wt% of an epoxy acrylate oligomer is utilized. Herein, it is found that a substantially higher amount of oligomer, i.e., an epoxy acrylate oligomer and/or an acrylate-functional urethane oligomer, are utilized, i.e, at least about 20 wt% up to about 65 wt%.

Epoxy acrylate oligomers particularly useful in the invention are bisphenol A acrylates having between 1 and 5 bisphenol A groups. Such oligomers are commercially available, e.g., Ebycryl® resins.

Acrylate-functional urethanes may be formed by reacting polyols with an excess of polyisocyanates to form NCO-terminated intermediate polymers and then reacting these intermediate polymers with OH-functional acrylates,

such as hydroxyethyl acrylate or hydroxyethyl methacrylate to provide acrylate functionality. Such resins are commercially available, e.g., such as those sold as Lundycryl® resins.

Another type of acrylate-functional urethanes useful in the invention have the general formula:

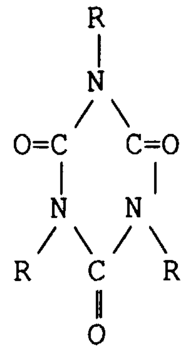

where R is - $(CH_2)_p$-NH-COO-$(CHY\text{-}CHY\text{-}O)_m$-CO-CX=$CH_2$, where X is H or $CH_3$, Y is H, $CH_3$, or $C_2H_5$, p is an integer from 1 to 36 and m is an integer from 1 to 14. Such trimers are described in European Patent Application EP 0 738 927 A2.

The high level of acrylate-functional oligomer incorporated into the compositions of the present invention is believed to function to break up the high crystallinity of the SMA backbone of the binder polymer and thereby achieve better encapsulation of circuitry traces. The photoimageable composition may optionally contain up to about 15 wt% of conventional mono- and polyfunctional acrylate monomers $B_3$) such as tetraethylene glycol diacrylate (TEGDA), trimethylol propane triacrylate (TMPTA), butanediol dimethacrylate (BDDMA) and pentaerythritol triacrylate (PETA). Additional multifunctional monomers include 1,5-pentanediol diacrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate.

To initiate polymerization of the monomers and/or oligomers upon exposure to actinic radiation, the photoimageable composition contains C) an appropriate photoinitiator(s) or photoinitiator chemical system. Suitable photoinitiators include benzoin ethers, benzil ketals, acetophenones, benzophenones and related compounds with amines. The photoinitiator chemical system preferably includes 9-phenyl acridine at between about 0.01 and about 2 wt% relative to total of A) plus B) plus C).

The composition generally contains additional minor components as is known in the art. For example, the composition generally contains a free-radical inhibitor to prevent premature thermal polymerization of the acrylate functional oligomers and monomers. Other conventional additives include dyes, flow control modifiers, anti-foaming agents, pigments, antioxidants, etc.

The components of the composition are dissolved in a suitable solvent, such as acetone or methyl ethyl ketone (MEK). Typically, the solids level of the composition is between about 20 and about 60%; however, this may vary depending on application.

To achieve post-development hardening through a thermal cure, the composition further contains between about 1 and about 5 wt% of an aminoplast, such a melamine-formaldehyde resin or a urea-formaldehyde resin. The aminoplast resin will cross-link through any OH groups present in the composition and, at elevated temperatures, i.e., above about 135°C, through the carboxylic acid functionality of the binder polymer. Preferred melamine-formaldehyde resins have methylated melamine moieties.

The composition is applied, either as a liquid composition, but preferably as a dry film layer to a printed circuit board so as to encapsulate the circuitry. If applied as a liquid, the composition must be dried to remove solvent prior to further processing. The composition, whether directly applied, or transferred from a dry film, is processed in a conventional manner. The composition is exposed through artwork to patterned actinic radiation and then developed in an alkaline aqueous solution, such as 1% sodium carbonate solution. The composition is subsequently heated, e.g., at temperatures of above about 135°C for a period sufficient to effect a thermal cure by reaction of the aminoplast with

the carboxylic acid functionality of the binder polymer.

The compositions of the present invention are tack-free, meaning that art-work may be contacted directly with the photoimageable composition without a " top coat" or polymeric layer between the artwork and the photoimageable composition. This tack-free attribute is achieved without any pre-exposure bake cycle. This tack-free attribute provides for enhanced resolution.

The compositions provide improved film flexibility which is of particular importance in tenting through-holes on printed circuit boards. This is particularly surprising because polymers containing high levels of styrene, i.e., greater than 30%, usually form films which are extremely brittle and easily damaged.

A very important advantage of the composition of the present invention is its high heat-resistance, i.e., the ability to withstand the 305°C heat stress to which solder masks may be repeatedly exposed, e.g., up to about 5 times during multiple soldering operations. Currently, such heat-resistance is found only in epoxy-based liquid systems.

Because the composition of the present invention is a one part system and can be provided as a layer of a dry film, as opposed to two part epoxy systems which must be applied as a liquid, the compositions as such dry film layers can cover and protect through-holes during processing. Other advantages of a dry film is the fact that no drying or equilibration of the composition is required before further processing, thereby avoiding the time delays of such steps.

The invention will now be described in greater detail by way of specific examples.

Example

A photoimageable composition in accordance with the invention is formulated as follows :

| Component | wt% |
|---|---|
| Esterified styrene maleic anhydride* | 65.96 |
| Ebycryl® 3500 (epoxy acrylate) | 23.74 |
| Lundycryl® (urethane acrylate | 2.65 |
| RO-501 (75% urethane acrylate/ 25% 3 mole ethoxylated trimethylolpropane triacrylate) | 5.27 |
| Resimine 735 (methylated melamine resin) | 2.38 |
| | 100.00 |
| 9-phenyl acridine (photoinitiator) Irgacure® 907 (2-methyl-(4 (methylthio)phenyl)-2- | 0.17 |
| (4-morpholinyl)-1-propanol) (photoinitiator) | 8.18 |
| Isopropyl thioxanthone (mixture of 2 and 4 isomers (photoinitiator) | 2.24 |
| Spectracure® G646507 (phthalocine green pigment | 1.18 |
| Modaflow® (acrylic flow modifier) | 0.39 |
| Benzatriazole | 0.04 |
| Syloid® 7000 (was treated fumed silica) (filler) | 5.93 |
| Methyl ethyl ketone (solvent) | 21.11 |
| Propylene glycol monomethyl ether acetate (solvent) | 0.66 |

*2:1 mole ratio S:MA, hal-esterified
3:1 mole ratio phenoxy ethanol:methanol, Mw = 40,000

The photoimageable composition was dissolved in methyl ethyl ketone at 55% solids. The composition was applied to a polyester support sheet and dried. Then a polyethylene protective sheet was applied. A film of 2.0 mil thickness was obtained. The polyethylene sheet was removed and the dried film with support sheet was laminated to a printed circuit board using a vacuum laminator. The polyester support sheet was removed, and artwork was laid directly on the photoimageable composition layer, and the photoimageable composition was exposed to 165 $mJ/cm^2$ actinic radiation through artwork. After removal of the artwork, the photoimageable composition was developed in 1% sodium carbonate monohydrate for 45 seconds at 29.4°C. The remaining photoimageable composition was then cured by baking at 150°C for 60 min.

**Claims**

**1.** An alkaline-aqueous developable photoimageable composition comprising

A) between 20 and 50 wt% of a binder polymer, said binder polymer (A) comprising a backbone formed of

between 45 and 75 mole percent styrene and between 25 and 55 mole percent maleic anhydride, and being esterified with an organic alcohol or mixture of organic alcohols each having a molecular weight between 32 and 200 so as to at least half-esterify the anhydride functionality provided by maleic anhydride, said polymer having an acid number between 110 and 270, and having a weight average molecular weight between 10,000 and 150,000,

B) between 20 and 75 wt% of photoimageable compounds comprising
between 20 and 60 wt% of acrylate-functional oligomers selected from:

$B_1$) acrylate functional urethane oligomers having weight average molecular weights between 400 and 3000,
$B_2$) epoxy acrylate oligomers having weight average molecular weights between 400 and 3000, and mixtures of ($B_1$) and ($B_2$),
and
($B_3$) from 0 to 15 wt% of acrylate-functional monomers,

C) between 1 and 5 wt% of an aminoplast,
and
D) between 1 and 15 wt% of a photoinitiator chemical system,

said weight percentages being based on total weight of components (A), (B) and (C).

**2.** A composition according to Claim 1 wherein the weight average molecular weight of said binder polymer is 60,000 or below.

**3.** A composition according to Claim 1 or Claim 2 wherein the weight average molecular weight of said binder polymer is 20,000 or above.

**4.** A composition according to any preceding Claim wherein the molecular weight of said esterifying alcohol(s) is below 130.

**5.** A composition according to any preceding Claim wherein said oligomers $B_1$) and/or $B_2$) have weight average molecular weights of 2000 or below.

**6.** A composition according to any preceding Claim wherein said photoinitiator chemical system (D) contains between 0.01 and 2 wt% 9-phenyl acridine based on total weight of (A) plus (B).

European Patent Office

# EUROPEAN SEARCH REPORT

Application Number
EP 99 30 5236

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A,D | EP 0 726 499 A (MORTON INT INC)<br>14 August 1996 (1996-08-14)<br>* page 2, line 48 - page 3, line 30 *<br>* examples *<br>* claims *<br>--- | 1-6 | G03F7/033 |
| A | EP 0 599 510 A (DU PONT UK)<br>1 June 1994 (1994-06-01)<br>* page 2, line 18 - line 29 *<br>* page 2, line 58 - page 3, line 37 *<br>* claims 4,12,13 *<br>--- | 1-6 | |
| A | GB 2 198 741 A (WOLFEN FILMFAB VEB)<br>22 June 1988 (1988-06-22)<br>* examples 1,3-6 *<br>----- | 1-6 | |
| | | | TECHNICAL FIELDS SEARCHED (Int.Cl.7) |
| | | | G03F |

The present search report has been drawn up for all claims

| Place of search | Date of completion of the search | Examiner |
|---|---|---|
| THE HAGUE | 14 October 1999 | Fiocco, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 99 30 5236

This annex lists the patent family members relating to the patent documents cited in the above-mentioned European search report.
The members are as contained in the European Patent Office EDP file on
The European Patent Office is in no way liable for these particulars which are merely given for the purpose of information.

14-10-1999

| Patent document cited in search report | Publication date | Patent family member(s) | Publication date |
|---|---|---|---|
| EP 0726499 A | 14-08-1996 | US 5576145 A | 19-11-1996 |
| | | US 5609991 A | 11-03-1997 |
| | | AT 171284 T | 15-10-1998 |
| | | AU 677537 B | 24-04-1997 |
| | | AU 4229496 A | 22-08-1996 |
| | | BR 9600360 A | 27-01-1998 |
| | | CA 2166177 A,C | 11-08-1996 |
| | | CN 1135611 A | 13-11-1996 |
| | | DE 69600644 D | 22-10-1998 |
| | | DE 69600644 T | 11-02-1999 |
| | | ES 2123320 T | 01-01-1999 |
| | | JP 8248634 A | 27-09-1997 |
| | | US 5698376 A | 16-12-1997 |
| | | US 5698370 A | 16-12-1997 |
| | | US 5773518 A | 30-06-1998 |
| EP 0599510 A | 01-06-1994 | GB 2273366 A | 15-06-1994 |
| | | CA 2102954 A | 19-05-1994 |
| | | DE 69310103 D | 28-05-1997 |
| | | DE 69310103 T | 13-11-1997 |
| | | ES 2101243 T | 01-07-1997 |
| | | JP 7001698 A | 06-01-1995 |
| | | US 5948599 A | 07-09-1999 |
| GB 2198741 A | 22-06-1988 | CH 669053 A | 15-02-1989 |
| | | DE 3641687 A | 16-06-1988 |
| | | FR 2609186 A | 01-07-1988 |

EPO FORM P0459

For more details about this annex : see Official Journal of the European Patent Office, No. 12/82